# EUROPEAN PATENT APPLICATION

(11) **EP 4 752 492 A2**
(43) Date of publication of application: **03.06.2026**
(21) Application number: 25218832.1
(22) Date of filing: 26.11.2025
(51) Int. Cl.: F28F 27/02, F28F 1/32, F28D 1/053

(54) **COOLING SYSTEM FOR USE IN COLD AMBIENT CONDITIONS**

(30) Priority: 28.11.2024 US 202463726247 P; 05.11.2025 US 202519380955
(71) Applicant: Vertiv Corporation, Westerville, OH 43082 (US)
(72) Inventor: COLE, Andrew Nathan, Westerville, 43082 (US)
(74) Representative: Cousens, Nico

(57) **Abstract**

A cooling system can include an evaporator for transferring heat from a heat source to a cooling fluid, a condenser for rejecting heat from the cooling fluid, a fan for inducing air flow through the condenser, a pump for pumping the cooling fluid, a controller, and a damper for selectively resisting air flow through the condenser. The controller can operate the cooling system in a pumped cooling mode when a temperature is below a threshold and reduce a speed of the fan when the temperature is below another, lower threshold. The damper can thermo-mechanically increase air flow resistance through the condenser.

## Description

This application claims the benefit of U.S. Provisional Patent Application No. 63/726,247 filed November 28, 2024.

### TECHNICAL FIELD

The present disclosure relates generally to cooling systems and more specifically relates to cooling system operation in cold ambient conditions.

### BACKGROUND

There is increasing demand for cooling systems that can efficiently manage larger heat loads, or cooling demands. For example, information technology (IT) equipment housed in data centers, and other heat sources, can have very large cooling demands. Cooling systems designed for high heat loads, or cooling demands, often suffer from imprecise control at lower heat loads, or cooling demands, and/or when an external ambient temperature is especially low. In other words, current cooling systems that can efficiently manage larger high heat loads, or cooling demands, often suffer from limited control at significant turn down.

There are currently many strategies for dealing with very low turn down on large cooling systems. For example, split condensing involves turning off one or more of a plurality of condensers at lower heat loads, or cooling demands, and/or at low ambient temperatures. However, such approaches are expensive and complex, often requiring additional equipment, and often still cannot adequately maintain proper system pressures and/or flow rates at very low heat loads, or cooling demands, and/or at very low ambient temperatures.

In some cooling systems, fans are often turned down to minimum operating speeds to meet low heat loads, or cooling demands, and/or at low ambient temperatures, and then off to meet very low loads, demands, and/or temperatures. When temperatures rise again, the fans are turned back on, and thus the fans are often cycled on and off to accommodate varying conditions, including high turn down with very low loads, demands, and/or temperatures. Such repeated cycling can be detrimental and inefficient.

### SUMMARY

Applicant has created new and useful devices, systems and methods for cooling system operation in cold ambient conditions. In at least one embodiment, a cooling system according to the disclosure can avoid cycling a fan, and/or other components, on and off during low cooling demand and/or cold ambient conditions. In at least one embodiment, a cooling system according to the disclosure can automatically and/or independently limit air flow through a heat exchanger, such as an external condenser, during low cooling demand and/or cold ambient conditions. In at least one embodiment, a cooling system according to the disclosure can provide for increased turn down capability and improved control precision at low ambient temperatures, without adding expensive components and/or complex controls.

In at least one embodiment, a cooling system can include an evaporator for transferring heat from a heat source to a cooling fluid, a condenser for rejecting heat from the cooling fluid, a fan for inducing air flow through the condenser, a damper for selectively limiting air flow through the condenser, a pump for selectively pumping the cooling fluid through the system, a controller, or any combination thereof. In at least one embodiment, the controller can operate the system in a pumped cooling mode when the temperature is below a first threshold, reduce a speed of the fan when the temperature is below a second threshold, or any combination thereof. In at least one embodiment, the first threshold can be higher than the second threshold and/or the damper can be or include a thermo-mechanical damper.

In at least one embodiment, the damper can be or include a thermo-mechanical portion of one or more fins of the condenser that flex or otherwise change position as the temperature varies below a third threshold. In at least one embodiment, the damper can be or include one or more thermo-mechanical fins that flex as the temperature varies below a third threshold. In at least one embodiment, the damper can be or include a plurality of thermo-mechanical blades that decrease air flow across the fins of the condenser as the temperature decreases. In at least one embodiment, the damper can include a first plurality of thermo-mechanical fins that flex as the temperature varies below a third threshold and/or a second plurality of thermo-mechanical fins that flex as the temperature varies below a fourth threshold. In at least one embodiment, the second threshold can be higher than the third threshold, which can be higher than the fourth threshold. In at least one embodiment, the damper can be or include a plurality of movable blades and a thermo-mechanical actuator that can move the blades. In at least one embodiment, the blades can decrease the air flowing through the condenser as the temperature decreases.

In at least one embodiment, the damper can automatically, and/or independently of the controller, limit air flow through the condenser according to the temperature. In at least one embodiment, the damper can remain fully open, minimally inhibiting air flow through the fins of the condenser, until the temperature decreases below a third threshold, which can be lower than the second threshold. In at least one embodiment, the controller can reduce the speed of the fan to a minimum fan speed when the temperature decreases to and below the third threshold.

In at least one embodiment, a heat exchanger, such as a condenser, can include at least one fluid path through the heat exchanger, a plurality of fins for rejecting heat from the at least one fluid path to air flowing across the fins, a damper for inhibiting air flow across the fins according to a temperature, or any combination thereof. In at least one embodiment, a cooling fluid can flow through the fluid path, which can be or include one or more tubular coils, one or more tubes, one or more manifolds, one or more reservoirs, or any combination thereof. In at least one embodiment, the fluid path and/or the fins can be made of one or more metals and/or other heat conductive material(s). In at least one embodiment, the fluid path and/or the fins can extract heat from the cooling fluid and reject that heat to ambient air and/or air flowing through the heat exchanger. In at least one embodiment, the temperature can be a fluid temperature of a cooling fluid flowing through the fluid path, a fluid path temperature of the fluid path, an air temperature of the air flowing between or across the fins, a fin temperature of the fins, or any combination thereof.

In at least one embodiment, one or more of the fins can include a thermo-mechanical portion. In at least one embodiment, the thermo-mechanical portion can be made of two different materials, such as metals which expand at different rates as they are heated, which can cause the thermo-mechanical portion to flex according to the temperature. In at least one embodiment, the damper can be or include the thermo-mechanical portion of the one or more of the fins. In at least one embodiment, the thermo-mechanical portion can decrease or resist air flow across the fins as the temperature decreases. In at least one embodiment, the thermo-mechanical portion can be disposed in an air flow path upstream and/or downstream of the fluid path. In at least one embodiment, the temperature can be or include an ambient air temperature entering the heat exchanger and/or a rejection air temperature exiting the heat exchanger. In at least one embodiment, any or all of the fins can include the thermo-mechanical portion. In at least one embodiment, less than all fins can include the thermo-mechanical portion.

In at least one embodiment, one or more of the fins can include a first thermo-mechanical portion that can flex as the temperature varies within a first range and/or a second thermo-mechanical portion that can flex as the temperature varies within a second range. In at least one embodiment, the first range can be higher than the second range, overlap with the second range, be exclusive of the second range, or any combination thereof. In at least one embodiment, the damper can be or include the thermo-mechanical portion(s).

In at least one embodiment, the damper can include a plurality of movable blades and/or a thermo-mechanical actuator that can move the blades between a fully open position and a fully closed position, e.g., based on temperature. In at least one embodiment, the blades can decrease the air flow or increase air flow resistance through the fins as the temperature decreases. In at least one embodiment, the blades can reduce air flow through the fins by 50% or more, up to and including completely stopping air flow through the fins, when in the fully closed position as compared to the fully open position. In at least one embodiment, the thermo-mechanical actuator can move the blades between the fully open position and the fully closed position in a continuous, non-discrete manner according to variations in the temperature. In at least one embodiment, the blades can be disposed in an air flow path upstream of the fins, downstream of the fins, between the fins, or any combination thereof.

In at least one embodiment, the damper can be or include a plurality of thermo-mechanical blades for decreasing air flow across the fins as the temperature decreases. In at least one embodiment, the blades can be disposed in an air flow path upstream of the fins, downstream of the fins, between the fins, or any combination thereof.

In at least one embodiment, a heat exchanger can include one or more fluid paths through the heat exchanger, one or more heat rejection fins in thermal communication with the fluid path, one or more thermo-mechanical fins, or any combination thereof. In at least one embodiment, the thermo-mechanical fins can be in thermal communication with the fluid path. In at least one embodiment, the heat rejection fins and/or the thermo-mechanical fins can reject heat from the fluid path to air flowing between the heat rejection fins and/or the thermo-mechanical fins. In at least one embodiment, the thermo-mechanical fins can flex according to a temperature. In at least one embodiment, any or all of the thermo-mechanical fins can be disposed in an air flow path of the air flowing between the heat rejection fins upstream of the heat rejection fins, downstream of the heat rejection fins, between the heat rejection fins, or any combination thereof. In at least one embodiment, the thermo-mechanical fins can decrease the air flowing between the heat rejection fins as the temperature decreases. In at least one embodiment, the thermo-mechanical fins can be aligned parallel to the heat rejection fins at a first temperature and non-parallel to the heat rejection fins at a second temperature lower than the first temperature.

In at least one embodiment, the heat rejection fins can also flex according to the temperature. In at least one embodiment, the thermo-mechanical fins can flex as the temperature varies within a first range and/or the heat rejection fins can flex as the temperature varies within a second range. In at least one embodiment, the first range can be higher than the second range, overlap with the second range, be exclusive of the second range, or any combination thereof.

### BRIEF DESCRIPTION OF THE DRAWINGS

FIG. 1 is a simplified schematic of one of many embodiments of a cooling system according to the disclosure.
FIGS. 2-4 are simplified diagrams of one of many embodiments of a heat exchanger with a damper for use with a cooling system according to the disclosure.
FIGS. 5-10 are simplified diagrams of one of many embodiments of a heat exchanger with flexible fins for use with a cooling system according to the disclosure.
FIGS. 11-13 are simplified diagrams of another one of many embodiments of a heat exchanger with a damper for use with a cooling system according to the disclosure.
FIG. 14 is a simplified diagram of a control scheme for use with a cooling system according to the disclosure.
FIGS. 15-16 are simplified diagrams of one of many embodiments of a heat exchanger with flexible fins for use with a cooling system according to the disclosure.
FIGS. 17-18 are simplified diagrams of another one of many embodiments of a heat exchanger with a damper for use with a cooling system according to the disclosure.
FIG. 19 is a simplified diagram of another one of many embodiments of a heat exchanger with flexible fins for use with a cooling system according to the disclosure.
FIGS. 20-21 are schematics of one of many embodiments of flexible fins for use with a cooling system according to the disclosure.
FIGS. 22-23 are schematics of another one of many embodiments of flexible fins for use with a cooling system according to the disclosure.
FIG. 24 is a schematic of yet another one of many embodiments of flexible fins for use with a cooling system according to the disclosure.
FIG. 25 is a simplified diagram of one of many embodiments of a portion of a cooling system according to the disclosure.

### DETAILED DESCRIPTION

The figures described above and the written description of specific structures and functions below are not presented to limit the scope of what Applicant has invented or the scope of the appended claims. Rather, the figures and written description are provided to teach any person skilled in the art to make and use the inventions for which patent protection is sought. Those skilled in the art will appreciate that not all features of a commercial embodiment of the inventions are described or shown for the sake of clarity and understanding. Persons of skill in this art will also appreciate that the development of an actual commercial embodiment incorporating aspects of the present inventions will require numerous implementation-specific decisions to achieve the developer's ultimate goal for the commercial embodiment. Such implementation-specific decisions may include, and likely are not limited to, compliance with system-related, business-related, government-related and other constraints, which may vary by specific implementation, location and from time to time. While a developer's efforts might be complex and time-consuming in an absolute sense, such efforts would be, nevertheless, a routine undertaking for those of skill in this art having benefit of this disclosure. It must be understood that the inventions disclosed and taught herein are susceptible to numerous and various modifications and alternative forms.

The use of a singular term, such as, but not limited to, "a," is not intended as limiting of the number of items. Also, the use of relational terms, such as, but not limited to, "top," "bottom," "left," "right," "upper," "lower," "down," "up," "side," and the like are used in the written description for clarity in specific reference to the figures and are not intended to limit the scope of the disclosures or the appended claims. The terms "including" and "such as" are illustrative and not limitative. The terms "couple," "coupled," "coupling," "coupler," and like terms are used broadly herein and can include any method or device for securing, binding, bonding, fastening, attaching, joining, inserting therein, forming thereon or therein, communicating, or otherwise associating, for example, mechanically, magnetically, electrically, chemically, operably, directly or indirectly with intermediate elements, one or more pieces of members together and can further include without limitation integrally forming one functional member with another in a unity fashion. The coupling can occur in any direction, including rotationally. Further, all parts and components of the disclosure that are capable of being physically embodied inherently include imaginary and real characteristics regardless of whether such characteristics are expressly described herein, including but not limited to characteristics such as axes, ends, inner and outer surfaces, interior spaces, tops, bottoms, sides, boundaries, dimensions (e.g., height, length, width, thickness), mass, weight, volume and density, among others.

Any process flowcharts discussed herein illustrate the operation of possible implementations of systems and methods according to various embodiments of the present disclosure. Each block in a flowchart may represent a module, segment, or portion of one or more of such implementations. In some implementations, the subject matter noted in the block(s) might occur out of the order depicted in the figures. For example, blocks shown in succession may, in fact, be executed substantially concurrently.

Applicant has created new and useful devices, systems and methods for cooling system operation in cold ambient conditions. In at least one embodiment, a cooling system according to the disclosure can avoid cycling a fan, and/or other components, on and off during low cooling demand and/or cold ambient conditions. In at least one embodiment, a cooling system according to the disclosure can automatically and/or independently limit air flow through a heat exchanger, such as an external condenser, during low cooling demand and/or cold ambient conditions. In at least one embodiment, a cooling system according to the disclosure can provide for increased turn down capability and improved control precision at low ambient temperatures, without adding expensive components and/or complex controls.

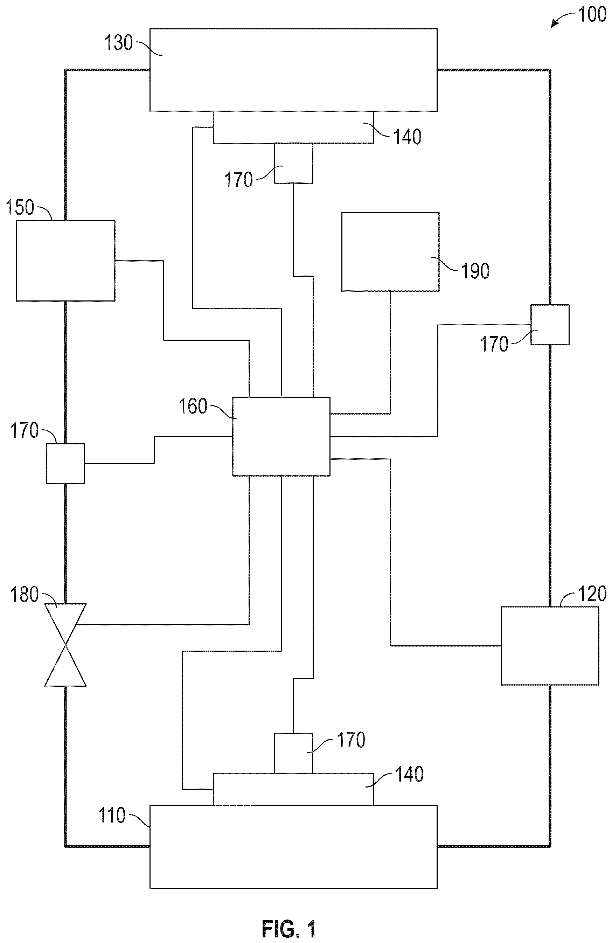

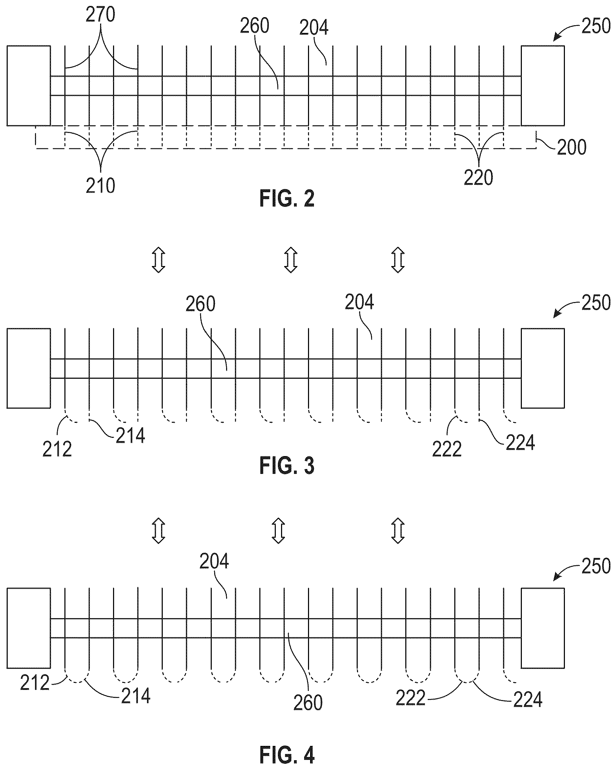

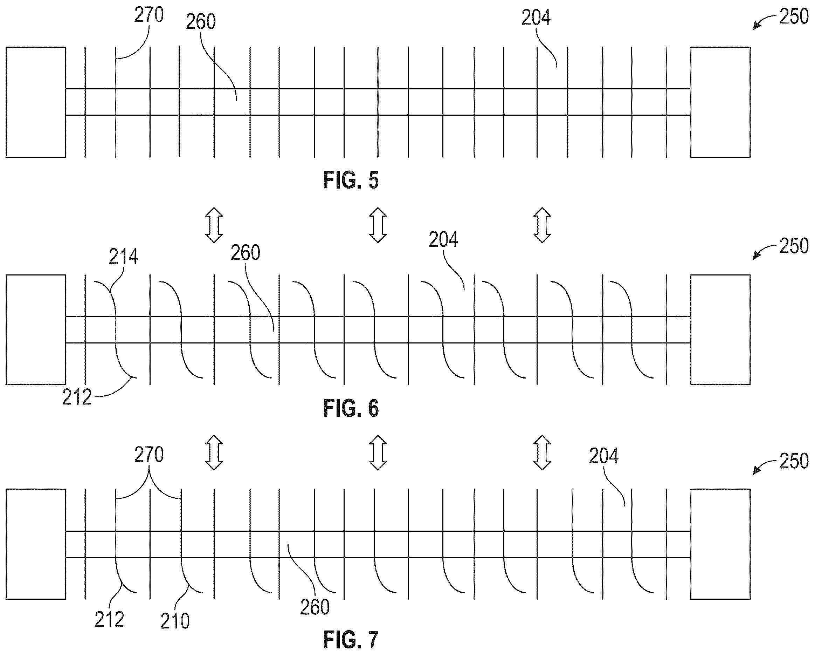

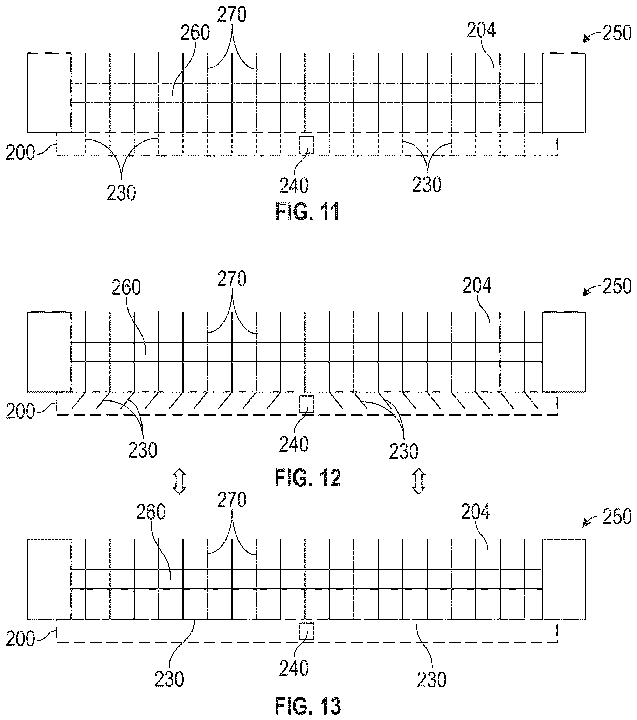

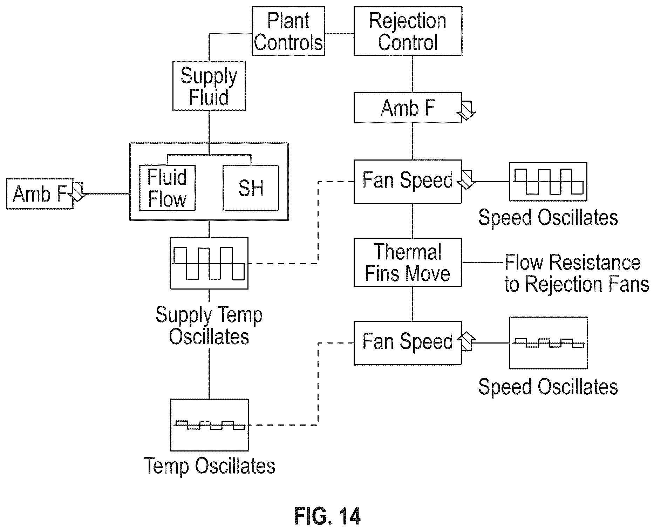

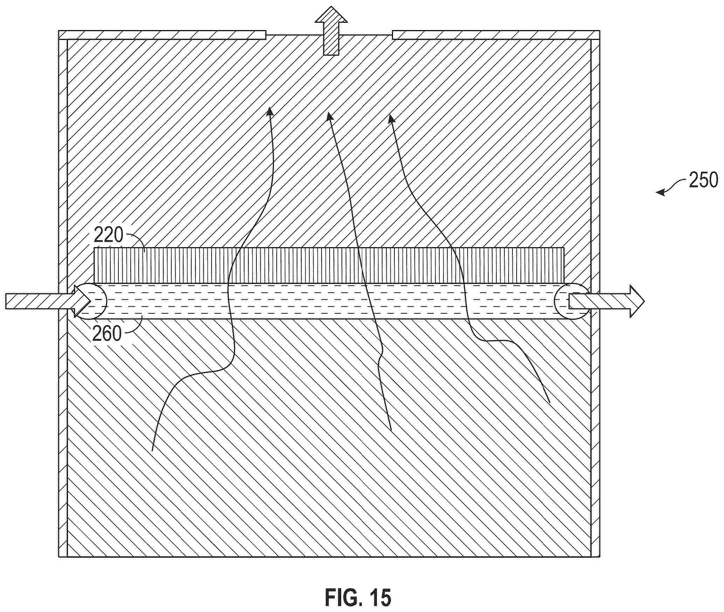

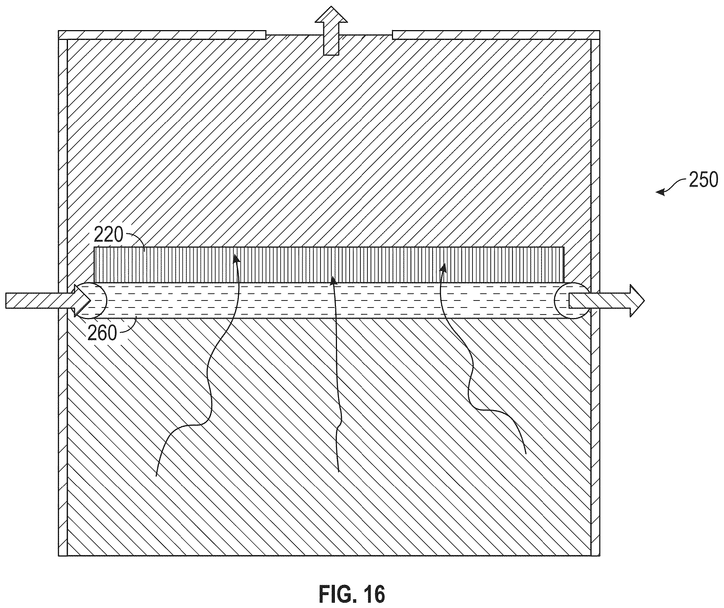

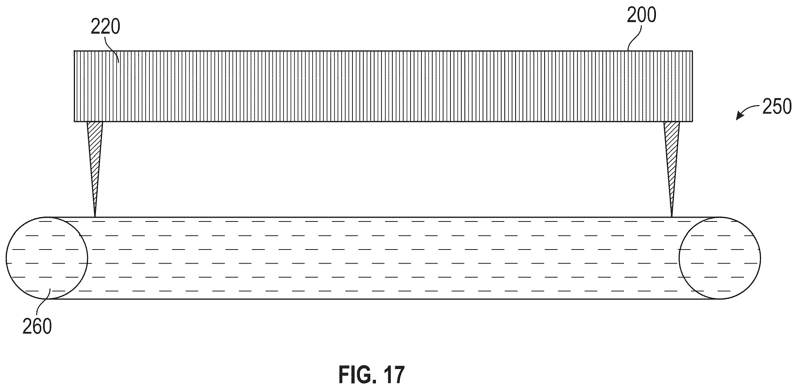

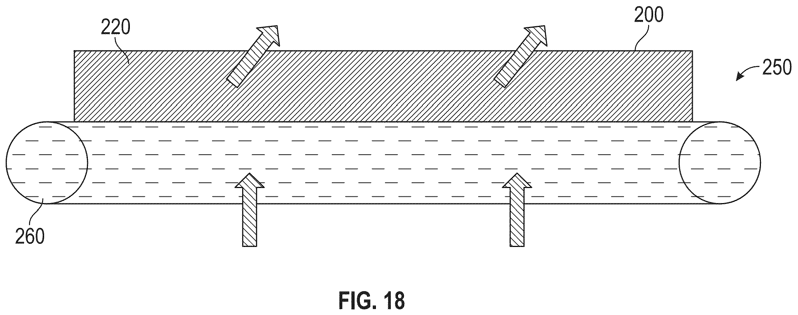

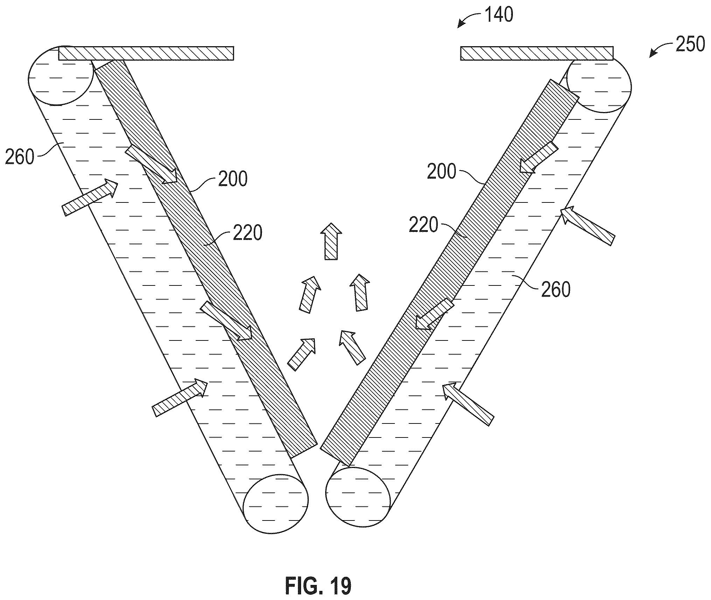

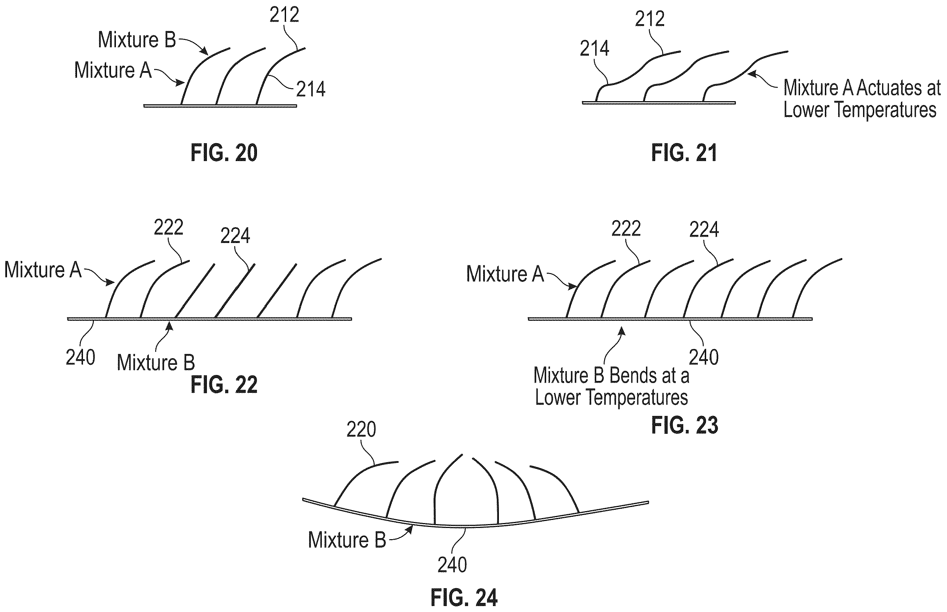

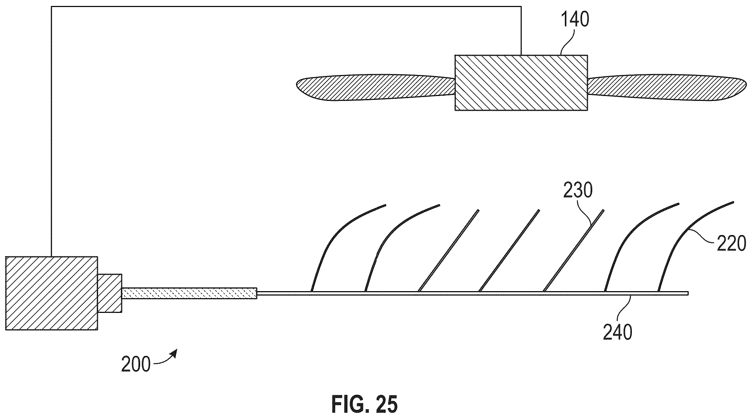

FIG. 1 is a simplified schematic of one of many embodiments of a cooling system according to the disclosure. FIGS. 2-4 are simplified diagrams of one of many embodiments of a heat exchanger with a damper for use with a cooling system according to the disclosure. FIGS. 5-10 are simplified diagrams of one of many embodiments of a heat exchanger with flexible fins for use with a cooling system according to the disclosure. FIGS. 11-13 are simplified diagrams of another one of many embodiments of a heat exchanger with a damper for use with a cooling system according to the disclosure. FIG. 14 is a simplified diagram of a control scheme for use with a cooling system according to the disclosure. FIGS. 15-16 are simplified diagrams of one of many embodiments of a heat exchanger with flexible fins for use with a cooling system according to the disclosure. FIGS. 17-18 are simplified diagrams of another one of many embodiments of a heat exchanger with a damper for use with a cooling system according to the disclosure. FIG. 19 is a simplified diagram of another one of many embodiments of a heat exchanger with flexible fins for use with a cooling system according to the disclosure. FIGS. 20-21 are schematics of one of many embodiments of flexible fins for use with a cooling system according to the disclosure. FIGS. 22-23 are schematics of another one of many embodiments of flexible fins for use with a cooling system according to the disclosure. FIG. 24 is a schematic of yet another one of many embodiments of flexible fins for use with a cooling system according to the disclosure. FIG. 25 is a simplified diagram of one of many embodiments of a portion of a cooling system according to the disclosure. FIGS. 1-25 are described in conjunction with one another.

In at least one embodiment, a cooling system 100 according to the disclosure can include one or more evaporators 110 for transferring heat from one or more heat sources to one or more cooling fluids, one or more pumps 150 for selectively pumping the cooling fluid through the system 100, one or more compressors 120 for selectively compressing a vaporized portion of the cooling fluid, one or more condensers 130 for rejecting heat from the cooling fluid, one or more fans 140 for inducing air flow through the evaporator 110 and/or the condenser 130, one or more dampers 200 for selectively or otherwise limiting or resisting air flow through the evaporator 110 and/or the condenser 130, or any combination thereof. In at least one embodiment, the heat source(s) can be or include information technology (IT) equipment housed in a data center. In at least one embodiment, the cooling system 100 can include one or more controllers 160 for controlling operation of one or more other system components.

In at least one embodiment, the controller 160 can monitor one or more sensors 170, such as one or more temperature sensors, flow sensors, humidity sensors, other sensors, or any combination thereof, with respect to the system 100. In at least one embodiment, the controller 160 can control the compressor(s) 120, the fan(s) 140, the pump(s) 150, one or more valves 180, or any combination thereof, such as in an effort to control one or more temperatures associated with the system 100. In at least one embodiment, the valves 180 can include one or more flow control valves, one or more expansion valves, one or more bypass valves, such as to selectively bypass the compressor 120 and/or the pump 150, or any combination thereof. In at least one embodiment, the controller 160 can communicate with one or more supervisory systems and/or one or more users through one or more user interfaces 190.

In at least one embodiment, the controller 160 can operate the compressor 120 (i.e., operate the system in a compressed refrigerant or cooling mode) when a temperature is above a threshold (e.g., a first threshold), operate the pump 150 (i.e., operate the system in a pumped refrigerant or cooling mode) when the temperature is below the first threshold, reduce a speed of the fan 140 when the temperature is below a second threshold, or any combination thereof. In at least one embodiment, the first threshold can be higher than the second threshold. For example, in at least one embodiment, the system 100 can be arranged for operating in a pumped cooling mode when adequate cooling can be accomplished by pumped cooling under applicable conditions, switching to a compressed cooling mode when additional cooling is called for, and/or reducing the cooling of the pumped cooling mode when called for by changing conditions (such as an increase in temperature difference between an ambient temperature and a "hot" cooling fluid temperature). As will be appreciated by a person of ordinary skill in the art having the benefits of the present disclosure, the above-mentioned thresholds and the other thresholds discussed herein can be chosen as required or desired to accomplish the results discussed in the present disclosure in accordance with a given physical implementation thereof, and such thresholds can (and often will) vary among implementations based on applicable factors (temperatures, pressures, cooling fluids, ambient conditions, etc.).

In at least one embodiment, the system 100 can include one or more dampers 200 for thermo-mechanically limiting or resisting air flow through at least a portion of the system 100, which can advantageously provide for, among other things, precise control of the system heat transfer coefficient in low ambient conditions. For example, one or more dampers 200 according to the disclosure can be or include one or more temperature-reactive or thermo-mechanical materials or structures, such as bimetal (or trimetal, tetrametal, etc.) or memory metal (i.e., a shape-memory alloy), and can be arranged for affecting air flow through a heat exchanger by changing shape based on temperature and increasing or decreasing air flow resistance through a flow path accordingly. In at least one embodiment, one or more dampers 200 can be utilized as fins of a heat exchanger, as dampers at an inlet and/or outlet of a flow path through the heat exchanger, or any combination thereof. In at least one embodiment, one or more dampers 200 can be positioned along an air flow path based on a desired temperature to which the damper 200 should respond (e.g., coil temperature, cooling fluid or refrigerant temperature, supply air temperature, return air temperature, and/or another temperature(s)). In this manner, the system 100 can provide for improved low ambient control and avoid unwanted fan cycling in a self-controlling and reliable way, whether alone or in combination with electronic system controls and/or control profiles.

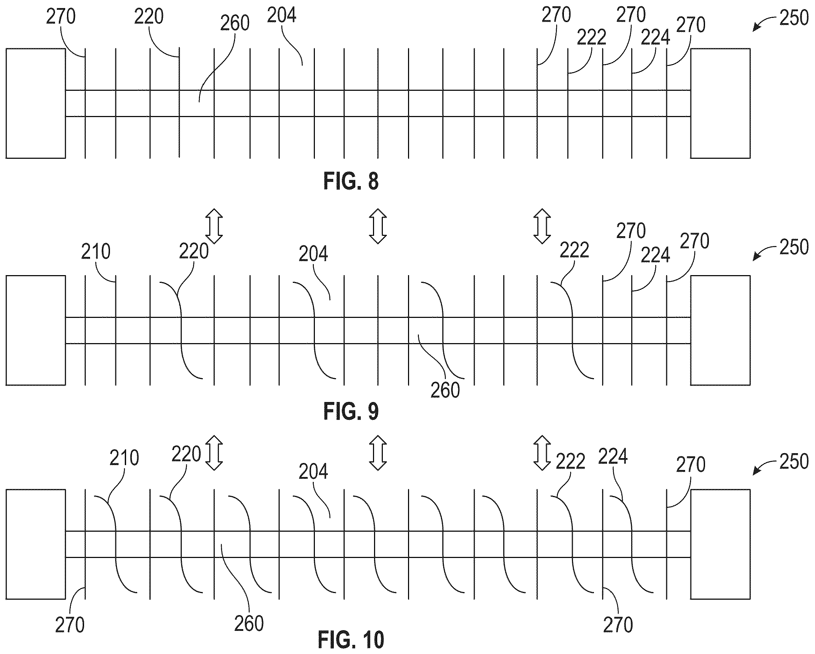

In at least one embodiment, the damper 200 can be or include one or more fins 270 of a heat exchanger 250 (such as the condenser 130) having one or more thermo-mechanical portions 210 that flex or otherwise change shape or position according to the temperature thereof, such as when the temperature falls below or otherwise reaches a threshold (e.g., a third threshold) (see, e.g., FIGS. 2-4). In at least one embodiment, the damper 200 can be or include one or more thermo-mechanical fins or blades 220 that flex or otherwise change shape or position in their entities according to the temperature thereof, such as when the temperature falls below or otherwise reaches the third threshold (see, e.g., FIGS. 9-10). In at least one embodiment, the thermo-mechanical portions 210 and/or the thermo-mechanical fins or blades 220 can increase resistance to air flow through air flow paths 204 between or adjacent to fins 270 of the heat exchanger 250 as the temperature decreases, such as by thermo-mechanically reacting to the temperature and bending or otherwise moving into the air flow path and/or into a position that resists air flow by reducing flow area and/or changing flow direction.

In at least one embodiment, the damper 200 can include a plurality of thermo-mechanical portions 210 and/or thermo-mechanical fins or blades 220 that react in the same manner to temperature. In at least one embodiment, the damper 200 can include a plurality of thermo-mechanical portions 210 and/or thermo-mechanical fins or blades 220 that react differently to temperature. For example, in at least one embodiment, the damper 200 can include a first set of thermo-mechanical fins or blades 222 that flex as the temperature varies below the third threshold and/or a second set of thermo-mechanical fins or blades 224 that flex as the temperature varies below another threshold, such as a fourth threshold (see, e.g., FIGS. 3-4 and 9-10). In at least one embodiment, the second threshold can be higher than the third threshold, and the third threshold can be higher than the fourth threshold, i.e., the system can be arranged for increasing air flow resistance as temperature decreases.

In at least one embodiment, the damper 200 can be or include one or more rotatable or otherwise movable blades 230 and a thermo-mechanical actuator 240 for moving the blades 230 and/or adding additional motion to the fins and/or blades according to temperature (see, e.g., FIG. 25). In at least one embodiment, like the thermo-mechanical portions 210 and/or thermo-mechanical fins or blades 220 described above, the actuator 240 can move the blades 230 and/or add additional motion to the fins and/or blades in response to one or more corresponding temperatures or thresholds for increasing air flow resistance through at least a portion of a heat exchanger 250. In at least one embodiment, air flow resistance can increase as the temperature decreases. In at least one embodiment, air flow resistance can increase as the temperature increases.

In at least one embodiment, the controller 160 can operate the compressor 120 when a temperature is above a first threshold, operate the pump 150 when the temperature is below the first threshold, reduce a speed of the fan 140 when the temperature is below a second threshold, reduce the speed of the fan 140 to a minimum fan speed when the temperature decreases to and/or below the third threshold, or any combination thereof. In at least one embodiment, the damper 200 can remain fully open, minimally inhibiting air flow through the fins of the heat exchanger 250, until the temperature decreases below the third threshold, or another dampening temperature. In at least one embodiment, the damper 200 can automatically, and/or independently of the controller 160, limit air flow through the heat exchanger 250 as the temperature varies within a range below the third threshold, or otherwise according to the temperature. In at least one embodiment, the damper 200 can remain fully closed, maximally inhibiting air flow through the fins of heat exchanger 250, as the temperature decreases below the range, or below a fourth threshold. In at least one embodiment, the first threshold can be higher than the second threshold, the second threshold can be higher than the third threshold, the third threshold can be higher than the fourth threshold, or any combination thereof. In at least one embodiment, the dampening temperature can be or include a temperature for increasing air flow resistance to prevent or delay shut off of one or more fans, such as a condenser fan.

In at least one embodiment, a heat exchanger 250, such as a condenser 130, can include one or more fluid paths 260 through the heat exchanger 250, a plurality of fins 270 in thermal communication with the fluid path 260 and arranged for rejecting heat from the at least one fluid path 260 to air flowing between or through the fins 270, one or more thermo-mechanical dampers 200 for increasing air flow resistance through the fins 270 according to a temperature, or any combination thereof. In at least one embodiment, a cooling fluid can flow through the fluid path 260, which can be or include one or more tubular coils, one or more tubes, one or more manifolds, one or more reservoirs, or any combination thereof. In at least one embodiment, the fluid path 260 and/or the fins 270, or any portion thereof, can be made of one or more metals and/or other thermally conductive material(s) (e.g., aluminum, copper, steel, or alloys thereof). In at least one embodiment, the fluid path 260 and/or the fins 270 can extract heat from the cooling fluid and reject that heat to ambient air and/or air flowing through the heat exchanger 250. In at least one embodiment, the damper 200 can increase air flow resistance through the fins 270 by thermo-mechanically dampening the air flow according to a temperature, such as a fluid temperature of a cooling fluid flowing through the fluid path 260, a fluid path temperature of the fluid path 260 itself, an air temperature of air flowing into, between and/or out of the fins 270, a fin temperature of the fins 270 themselves, or any combination thereof.

In at least one embodiment, one or more of the fins 270 can include one or more thermo-mechanical portions 210 arranged for increasing air flow resistance through the fins 270 by at least partially redirecting and/or blocking air flow upon reaching a temperature. In at least one embodiment, the thermo-mechanical portions 210 can be made of two different materials, such as metals which expand at different rates as they are heated, which can cause the thermo-mechanical portions 210 to flex according to temperature. In at least one embodiment, the damper 200 can be or include the thermo-mechanical portion(s) 210 of one or more of the fins 270. In at least one embodiment, the thermo-mechanical portions 210 can increase air flow resistance between or through the fins 270 as the temperature decreases. In at least one embodiment, the thermo-mechanical portions 210 can be disposed along an air flow path through the fins 270, upstream and/or downstream of the fluid path 260, and can change a shape, size and/or direction of the air flow path based on a temperature. In at least one embodiment, the temperature can be or include an air temperature of air entering the heat exchanger 250 and/or an air temperature of air exiting the heat exchanger 250. In at least one embodiment, all of the fins 270 can include one or more thermo-mechanical portions 210, such as on an air inlet (or upstream) end, an air outlet (or downstream) end, or both. In at least one embodiment, one or more of the fins 270 can include one or more thermo-mechanical portions 210 and one or more others of the fins 270 need not include the thermo-mechanical portions 210.

In at least one embodiment, one or more of the fins 270 can include a first thermo-mechanical portion 212 that can flex as the temperature varies within a first range and a second thermo-mechanical portion 214 that can flex as the temperature varies within a second range, such as for increasing and/or decreasing air flow resistance collectively, successively, and/or in stepped fashion. In at least one embodiment, the first range can be higher than the second range. In at least one embodiment, the first range can overlap with the second range. In at least one embodiment, the first range can be exclusive of the second range.

In at least one embodiment, the damper 200 or a portion thereof, such as any of the thermo-mechanical fins or blades 220, 222, 224 and/or the thermo-mechanical portions 210, 212, 214 of the fins 270 (i.e., as applicable depending on an implementation at hand), can be an integral part of the heat exchanger 250, for instance, in new-build implementations. In at least one embodiment, the damper 200 or a portion thereof, such as any of the thermo-mechanical fins or blades 220, 222, 224 and/or the thermo-mechanical portions 210, 212, 214 of the fins 270 (i.e., as applicable depending on an implementation at hand), can be built separately from the heat exchanger 250 and coupled thereto or disposed relative to an air flow path thereof, for instance, in retrofit implementations. In at least one embodiment, the thermo-mechanical fins or blades 220, 222, 224 and the fins 270 having thermo-mechanical portions 210, 212, 214 can be functional equivalents. In at least one embodiment, the thermo-mechanical fins or blades 220, 222, 224 and the fins 270 having thermo-mechanical portions 210, 212, 214 can have different air flow resistance characteristics. Similarly, any two or more fins or blades 220 and/or any two or more fins 270 having thermo-mechanical portions 210 can have the same or different air flow resistance characteristics, as required or desired in accordance with a given implementation of the disclosure.

In at least one embodiment, the damper 200 can include one or more movable or adjustable blades 230 and one or more thermo-mechanical actuators 240 arranged for moving the blades 230 among a fully open position, a fully closed position and/or one or more interim positions based on temperature (see, e.g., FIGS. 11-13). In at least one embodiment, the actuator 240 can move the blades 230 to increase air flow resistance for air flowing across the fins 270 as the temperature decreases. In at least one embodiment, the blades 230 can reduce air flow through the fins 270 by 50% or more, up to and including completely stopping air flow through the fins 270, when in the fully closed position as compared to the fully open position.

In at least one embodiment, the thermo-mechanical actuator 240 can move the blades 230 between the fully open position and the fully closed position in a continuous, non-discrete manner according to variations in the temperature. The blades 230 can be disposed in an air flow path upstream of the fins 270, downstream of the fins 270, in between the fins 270, or any combination thereof, as required or desired for a given implementation of the disclosure. In at least one embodiment, one or more of the blades 230 can be of a fixed size and shape and the thermo-mechanical actuator 240 can be arranged for rotating or sliding the blades in one or more directions for selectively resisting air flow through the heat exchanger 250. In at least one embodiment, one or more thermo-mechanical blades 220 and/or one or more fins 270 having one or more thermo-mechanical portions 210 can be utilized in combination with one or more blades 230, which can include being coupled to actuator 240.

In at least one embodiment, a heat exchanger 250 can include one or more fluid paths 260 through the heat exchanger 250, one or more heat rejection fins 270 in thermal communication with the fluid path 260, one or more thermo-mechanical fins 220, or any combination thereof. In at least one embodiment, the thermo-mechanical fins 220 can be in thermal communication with the fluid path 260. In at least one embodiment, the heat rejection fins 270 and/or the thermo-mechanical fins 220 can reject heat from the fluid path 260 to air flowing between the heat rejection fins 270 and/or the thermo-mechanical fins 220. In at least one embodiment, the thermo-mechanical fins 220 can flex according to a temperature. In at least one embodiment, any or all of the thermo-mechanical fins 220 can be disposed in an air flow path upstream of the heat rejection fins 270, downstream of the heat rejection fins 270, between the heat rejection fins 270, or any combination thereof. In at least one embodiment, the thermo-mechanical fins 220 can decrease or reduce air flow through or across the heat rejection fins 270 as the temperature decreases. In at least one embodiment, the thermo-mechanical fins 220 can be aligned parallel to (i.e., at least substantially parallel to) the heat rejection fins 270 at a first temperature and can be aligned in a non-parallel manner relative to the heat rejection fins 270 at a second temperature, such as a lower temperature.

In at least one embodiment, a first set of thermo-mechanical fins 222 can flex as the temperature varies within a first range and a second set of thermo-mechanical fins 224 can flex as the temperature varies within a second range. In at least one embodiment, a first set of thermo-mechanical portions 212 can flex as the temperature varies within the first range and a second set of thermo-mechanical portions 214 can flex as the temperature varies within the second range. In at least one embodiment, the first range can be higher than the second range. In at least one embodiment, the first range can overlap with the second range. In at least one embodiment, the first range can be exclusive of the second range.

In at least one embodiment, any or all of the heat rejection fins 270 can flex according to the temperature. In at least one embodiment, any or all of the thermo-mechanical fins 220 can flex as the temperature varies within a first range and/or any or all of the heat rejection fins 270 can flex as the temperature varies within a second range. In at least one embodiment, the damper 200 can include one or more thermo-mechanical fins 220 that flex as the temperature varies within a range coupled to a thermo-mechanical actuator 240 (e.g., a temperature-sensitive substrate, rail, or arm) that flexes as the temperature varies within a range, which can be the same range or a different range. In at least one embodiment, one range can be higher than another range. In at least one embodiment, two or more ranges can overlap with one another. In at least one embodiment, two or more ranges can be exclusive of one another. In at least one embodiment, each of one or more thermo-mechanical fins and/or portions 210, 220, 270 can include a plurality of portions that react differently to temperature and/or react to different temperatures, such as, for example, by way of being composed of different thermo-mechanical materials and/or different combinations and/or mixtures of thermo-mechanical materials.

In at least one embodiment, one or more dampers 200, including without limitation any of the illustrative damper configurations shown and/or described herein, can allow, limit, prevent, resist or otherwise manipulate or control air flow automatically and/or independently of the controller 160. In at least one embodiment, one or more thermo-mechanical fins and/or portions 210, 220, 270, including without limitation any of the illustrative configurations shown and/or described herein, can allow, limit, prevent, resist or otherwise manipulate or control air flow automatically and/or independently of the controller 160. In at least one embodiment, one or more thermo-mechanical actuators 240 and/or moveable blades 230 (and/or other fins or blades), including without limitation any of the illustrative configurations shown and/or described herein, can allow, limit, prevent, resist or otherwise manipulate or control air flow automatically and/or independently of the controller 160. In at least one embodiment, any of the foregoing can operate in cooperation or conjunction with one or more actuators, blades, fins, dampening components and/or other components that operate in accordance with a signal from and/or other communication with one or more other system components, such as, for example, the controller 160 and/or the fan 140.

In at least one embodiment, a cooling system can include an evaporator for transferring heat from a heat source to a cooling fluid, a condenser for rejecting heat from the cooling fluid, a fan for inducing air flow through the condenser, a damper for selectively limiting air flow through the condenser, a pump for selectively pumping the cooling fluid through the system, a compressor for selectively compressing a vaporized portion of the cooling fluid and inducing the cooling fluid to flow through the system, a controller, or any combination thereof. In at least one embodiment, the controller can operate the compressor when a temperature is above a first threshold, operate the pump when the temperature is below the first threshold, reduce a speed of the fan when the temperature is below a second threshold, or any combination thereof. In at least one embodiment, the first threshold can be higher than the second threshold.

In at least one embodiment, the damper can be or include a thermo-mechanical portion of one or more fins of the condenser that can flex as the temperature varies below a third threshold. In at least one embodiment, the damper can be or include one or more thermo-mechanical fins that can flex as the temperature varies below a third threshold. In at least one embodiment, the damper can be or include a plurality of thermo-mechanical blades that can decrease the air flowing between fins of the condenser as the temperature decreases. In at least one embodiment, the damper can include a first plurality of thermo-mechanical fins that can flex as the temperature varies below a third threshold and/or a second plurality of thermo-mechanical fins that can flex as the temperature varies below a fourth threshold. In at least one embodiment, the second threshold can be higher than the third threshold, which can be higher than the fourth threshold. In at least one embodiment, the damper can be or include a plurality of movable blades and a thermo-mechanical actuator that can move the blades. In at least one embodiment, the blades can decrease the air flowing through the condenser as the temperature decreases.

In at least one embodiment, the damper can automatically, and/or independently of the controller, limit air flow through the condenser according to the temperature. In at least one embodiment, the damper can remain fully open, minimally inhibiting air flow through the fins of the condenser, until the temperature decreases below a third threshold, which can be lower than the second threshold. In at least one embodiment, the controller can reduce the speed of the fan to a minimum fan speed when the temperature decreases to and below the third threshold.

In at least one embodiment, a heat exchanger, such as a condenser, can include at least one fluid path through the heat exchanger, a plurality of fins in thermal communication with the fluid path for rejecting heat from the at least one fluid path to air flowing across the fins, a damper for inhibiting air flow across the fins according to a temperature, or any combination thereof. In at least one embodiment, a cooling fluid can flow through the fluid path, which can be or include one or more tubular coils, one or more tubes, one or more manifolds, one or more reservoirs, or any combination thereof. In at least one embodiment, the fluid path and/or the fins can be made of one or more metals and/or other heat conductive material(s). In at least one embodiment, the fluid path and/or the fins can extract heat from the cooling fluid and reject that heat to ambient air and/or air flowing through the heat exchanger. In at least one embodiment, the temperature can be a fluid temperature of a cooling fluid flowing through the fluid path, a fluid path temperature of the fluid path, an air temperature of the air flowing between or across the fins, a fin temperature of the fins, or any combination thereof.

In at least one embodiment, one or more of the fins can include a thermo-mechanical portion. In at least one embodiment, the thermo-mechanical portion can be made of two different materials, such as metals which expand at different rates as they are heated, which can cause the thermo-mechanical portion to flex according to the temperature. In at least one embodiment, the damper can be or include the thermo-mechanical portion(s) of the one or more fins. In at least one embodiment, the thermo-mechanical portion can increase resistance to air flow between or through the fins as the temperature decreases. In at least one embodiment, at least a portion of the thermo-mechanical portion can be disposed in an air flow path upstream and/or downstream of the fluid path. In at least one embodiment, the temperature can be or include an ambient air temperature of air entering the heat exchanger and/or a rejection air temperature of air exiting the heat exchanger. In at least one embodiment, any or all of the fins can include the thermo-mechanical portion. In at least one embodiment, less than all of the fins can include the thermo-mechanical portion.

In at least one embodiment, one or more of the fins can include a first thermo-mechanical portion that can flex as the temperature varies within a first range and/or a second thermo-mechanical portion that can flex as the temperature varies within a second range. In at least one embodiment, the first range can be higher than the second range, overlap with the second range, be exclusive of the second range, or any combination thereof. In at least one embodiment, the damper can be or include the thermo-mechanical portion(s).

In at least one embodiment, the damper can include a plurality of movable blades and/or a thermo-mechanical actuator that can move the blades, such as according to the temperature, between a fully open position and a fully closed position. In at least one embodiment, the blades can limit air flow across the fins as the temperature decreases. In at least one embodiment, the blades can reduce air flow across the fins by 50% or more, up to and including completely stopping air flow across the fins, when in the fully closed position as compared to the fully open position. In at least one embodiment, the thermo-mechanical actuator can move the blades between the fully open position and the fully closed position in a continuous, non-discrete manner according to variations in the temperature. In at least one embodiment, the blades can be disposed in an air flow path upstream of the fins, downstream of the fins, between the fins, or any combination thereof.

In at least one embodiment, the damper can be or include a plurality of thermo-mechanical blades for decreasing air flow through the fins as the temperature decreases. In at least one embodiment, the blades can be disposed in an air flow path upstream of the fins, downstream of the fins, between the fins, or any combination thereof.

In at least one embodiment, a heat exchanger can include one or more fluid paths through the heat exchanger, one or more heat rejection fins in thermal communication with the fluid path, one or more thermo-mechanical fins, or any combination thereof. In at least one embodiment, the thermo-mechanical fins can be in thermal communication with the fluid path. In at least one embodiment, the heat rejection fins and/or the thermo-mechanical fins can reject heat from the fluid path to air flowing between the heat rejection fins and/or the thermo-mechanical fins. In at least one embodiment, the thermo-mechanical fins can flex according to a temperature. In at least one embodiment, any or all of the thermo-mechanical fins can be disposed in an air flow path of the air flowing between the heat rejection fins upstream of the heat rejection fins, downstream of the heat rejection fins, between the heat rejection fins, or any combination thereof. In at least one embodiment, the thermo-mechanical fins can decrease the air flowing between the heat rejection fins as the temperature decreases. In at least one embodiment, the thermo-mechanical fins can be aligned parallel to the heat rejection fins at a first temperature and non-parallel to the heat rejection fins at a second temperature lower than the first temperature.

In at least one embodiment, the heat rejection fins can also flex according to the temperature. In at least one embodiment, the thermo-mechanical fins can flex as the temperature varies within a first range and/or the heat rejection fins can flex as the temperature varies within a second range. In at least one embodiment, the first range can be higher than the second range, overlap with the second range, be exclusive of the second range, or any combination thereof.

Other and further embodiments utilizing one or more aspects of the disclosure can be devised without departing from the Applicant's disclosure. For example, the devices, systems and methods can be implemented for numerous different types and sizes in numerous different industries. Further, the various methods and embodiments of the devices, systems and methods can be included in combination with each other to produce variations of the disclosed methods and embodiments. Discussion of singular elements can include plural elements and vice versa. The order of steps can occur in a variety of sequences unless otherwise specifically limited. The various steps described herein can be combined with other steps, interlineated with the stated steps, and/or split into multiple steps. Similarly, elements have been described functionally and can be embodied as separate components or can be combined into components having multiple functions.

The disclosures have been described in the context of preferred and other embodiments and not every embodiment of the disclosures has been described. Obvious modifications and alterations to the described embodiments are available to those of ordinary skill in the art having the benefits of the present disclosure. The disclosed and undisclosed embodiments are not intended to limit or restrict the scope or applicability of the disclosures conceived of by the Applicant, but rather, in conformity with the patent laws, Applicant intends to fully protect all such modifications and improvements that come within the scope of the following claims.

## Claims

1. A heat exchanger (250) comprising:
a fluid path through the heat exchanger (260);
a plurality of fins (270) in thermal communication with the fluid path and configured to reject heat from the fluid path to air flowing across the plurality of fins; and
a damper (200) configured to resist air flow across the plurality of fins according to a temperature.

2. The heat exchanger as set forth in claim 1, wherein the temperature is a fluid temperature of a cooling fluid flowing through the fluid path.

3. The heat exchanger as set forth in claim 1 or 2, wherein the temperature is a fluid path temperature of the fluid path.

4. The heat exchanger as set forth in any preceding claim, wherein the temperature is an air temperature, and/or,
wherein the temperature is a fin temperature of one or more of the plurality of fins.

5. The heat exchanger as set forth in any preceding claim, wherein at least one of the plurality of fins includes a thermo-mechanical portion (210) configured to change position according to the temperature; and wherein the damper comprises the thermo-mechanical portion.

6. The heat exchanger as set forth in claim 5, wherein the thermo-mechanical portion is configured to increase air flow resistance along an air flow path adjacent to the at least one fin as the temperature decreases, and/or,
wherein the thermo-mechanical portion is disposed upstream of the fluid path and
wherein the temperature is an ambient air temperature of ambient air entering the heat exchanger.

7. The heat exchanger as set forth in claim 5 or 6, wherein the thermo-mechanical portion is disposed downstream of the fluid path and wherein the temperature is a rejection air temperature of air exiting the heat exchanger.

8. The heat exchanger as set forth in any preceding claim, wherein two or more of the plurality of fins includes a thermo-mechanical portion configured to change position according to the temperature; and wherein the damper comprises the thermo-mechanical portions.

9. The heat exchanger as set forth in claim 8, wherein each of the plurality of fins includes a thermo-mechanical portion configured to change position according to the temperature.

10. The heat exchanger as set forth in any preceding claim, wherein at least one of the plurality of fins includes a first thermo-mechanical portion (212) configured to change position as the temperature varies within a first range; wherein at least one of the plurality of fins includes a second thermo-mechanical portion (214) configured to change position as the temperature varies within a second range; wherein the first range is higher than the second range; and wherein the damper comprises the first and second thermo-mechanical portions, and optionally,
wherein the first range is exclusive of the second range.

11. The heat exchanger as set forth in any preceding claim wherein the damper comprises a plurality of movable blades (230) coupled to a thermo-mechanical actuator (240); and wherein the thermo-mechanical actuator is configured to move the blades among two more positions according to the temperature.

12. The heat exchanger as set forth in claim 11, wherein the damper is configured to increase air flow resistance across the fins as the temperature decreases.

13. The heat exchanger as set forth in claim 11 or 12, wherein the damper is configured to reduce air flow across the fins by at least 50% when in a fully closed position as compared to a fully open position, and/or,
wherein the thermo-mechanical actuator is configured to move the blades continuously as the temperature varies within a range.

14. The heat exchanger as set forth in any of claims 11 to 13, wherein the blades are disposed in an air flow path upstream of the fins, and/or,
wherein the blades are disposed in an air flow path downstream of the fins.

15. The heat exchanger as set forth in any preceding claim, wherein the damper comprises a plurality of thermo-mechanical blades configured to move among two more positions according to the temperature and configured to decrease air flow across the fins as the temperature decreases.
